# EUROPEAN PATENT APPLICATION

(11) **EP 1 014 758 A2**
(43) Date of publication of application: **28.06.2000**
(21) Application number: 99310607.9
(22) Date of filing: 24.12.1999
(51) Int. Cl.: H05B 33/04

(54) **Organic EL device**

(30) Priority: 25.12.1998 JP 37027998
(71) Applicant: TDK Corporation, Chuo-ku, Tokyo 103-8272 (JP)
(72) Inventor: Endo, Hiroyuki, c/o TDK Corporation, Tokyo 103-8272 (JP); Onitsuka, Osamu, c/o TDK Corporation, Tokyo 103-8272 (JP); Hayakawa, Toshio, c/o TDK Corporation, Tokyo 103-8272 (JP); Ebisawa, Akira, c/o TDK Corporation, Tokyo 103-8272 (JP); Kawashima, Masayuki, c/o TDK Corporation, Tokyo 103-8272 (JP)
(74) Representative: Wise, Stephen James

(57) **Abstract**

In an organic EL device comprising a substrate (1), an organic EL structure (2) on the substrate, and a sealing member (3) enclosing the organic EL structure, a mixture of a desiccant and a high molecular weight organic compound having a water absorption of up to 1.0% as measured at 23°C for 24 hours according to ASTM D570 is coated to the inside surface of the sealing member (3). The device maintains its initial performance over a long period of time and can be manufactured through simple sealing steps at low cost.

## Description

This invention relates to an organic electroluminescent (EL) device using organic compounds, and more particularly, to a sealing means for protecting an organic EL structure on a substrate.

### BACKGROUND OF THE INVENTION

Recently, active research works have been made on organic EL devices. As a basic configuration, the organic EL device includes a hole injecting electrode, a thin film formed thereon by evaporating a hole transporting material such as triphenyldiamine (TPD), a light emitting layer deposited thereon of a fluorescent material such as an aluminum quinolinol complex (Alq3), and a metal electrode or electron injecting electrode formed thereon from a metal having a low work function such as magnesium. Such organic EL devices are attractive in that they can achieve a very high luminance ranging from several 100 to several 10,000 cd/m² with a drive voltage of approximately 10 volts.

Organic EL devices are very sensitive to moisture. Contact with moisture can cause serious problems including separation between the light emitting layer and the electrode layer, deterioration of constituent materials, formation of non-light-emitting zones known as dark spots, and reduction of the luminous area. As a result, the EL devices fail to maintain light emission of the desired quality.

One known solution to this problem is to shield an organic EL multilayer structure on a substrate from the exterior by tightly securing a gas-tight casing or sealing layer to the substrate so as to enclose the EL structure, as disclosed in JP-A 5-36475, 5-89959, and 7-169567.

Despite the provision of such casings or sealing layers, moisture gradually penetrates in the interior with the lapse of drive time whereby the devices deteriorate in several aspects, such as a drop of light emission luminance, generation or enlargement of dark spots, and reduction of the luminous area. Eventually the devices become unusable because of failure of light emission.

It was also proposed to accommodate the organic EL structure in a gas-tight casing in which a desiccant is contained. For example, JP-A 3-261091 discloses diphosphorus pentoxide (P₂O₅) as the desiccant. However, P₂O₅ tends to absorb moisture and becomes liquid (deliquescence) and thus forms phosphoric acid, which can be detrimental to the organic EL structure. The introduction of P₂O₅ into the casing requires a careful limited procedure, which is impractical.

JP-A 6-176867 discloses an organic EL device enclosed with an external protective casing containing a fine powdery solid desiccant. Exemplary fine powdery solid desiccants are zeolite, active alumina, silica gel, and calcium oxide. The extra steps of introducing the fine powdery solid desiccant into the casing and attaching the casing with the desiccant filled therein make the manufacturing process complex. If the desiccant of the type that physically adsorbs water, typically zeolite, is disposed within the casing in potential contact with the organic EL device, the desiccant releases the once adsorbed water by the heat associated with the light emission of the EL device. The lifetime of the device is not fully long.

JP-A 9-148066 discloses desiccants in the form of compounds capable of chemically adsorbing moisture and maintaining a solid state even after moisture absorption, for example, alkali metal oxides, alkaline earth metal oxides, sulfates, and metal halides. Because of the chemical adsorption, once water is adsorbed, these compounds no longer release the water, ensuring a longer lifetime to the device. However, the retention of the solid desiccant within the gas-tight case is difficult and requires extra steps, and the lifetime of the device is still insufficient.

JP-A 5-114486 and 5-41281 disclose to keep an organic EL device in an inert liquid compound in the form of a fluorocarbon containing a desiccant. This approach is effective to some extent for protecting the organic EL device from moisture, but requires the step of introducing the inert liquid compound containing a desiccant, that is, a cumbersome sealing step.

Of the prior art sealing techniques mentioned above, some are insufficient in suppressing degradation phenomena including a reduction of luminance with the lapse of driving time and the development and growth of dark spots. Other techniques have some sealing effects, but suffer from other problems including the complexity and expense of sealing steps.

### SUMMARY OF THE INVENTION

Therefore, an object of the invention is to provide an organic EL device which effectively suppresses the deterioration with time of the device including a reduction of luminance with the lapse of driving time and the development and growth of dark spots, maintains its initial performance over a long period of time, and can be manufactured through simple sealing steps at low cost.

The invention provides an organic electroluminescent (EL) device comprising a substrate, an organic EL structure formed on the substrate, and a sealing member enclosing the organic EL structure for providing a seal thereto. A mixture of a desiccant and a high molecular weight organic compound having a water absorption of up to 1.0% as measured at 23°C for 24 hours according to ASTM D570 is disposed on the inside surface of the sealing member. The organic compound is preferably soluble in hydrocarbon or halogenated hydrocarbon solvents.

### BRIEF DESCRIPTION OF THE DRAWING

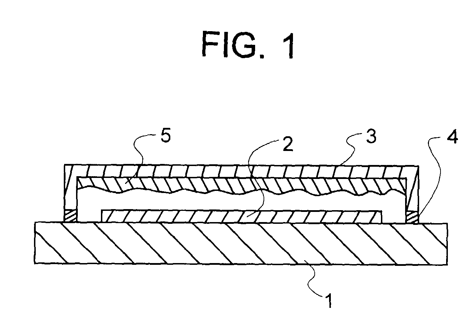

The only figure, FIG. 1 is a schematic cross-sectional view of an organic EL device according to one embodiment of the invention.

### DESCRIPTION OF THE PREFERRED EMBODIMENTS

The organic EL device of the invention has an organic EL structure formed on a substrate. A sealing member encloses the organic EL structure for sealing the structure from the exterior. Disposed on the inside of the sealing member is a mixture of a desiccant and a high molecular weight organic compound (sometimes referred to simply as resin) having a water absorption of up to 1.0% as measured at 23°C for 24 hours according to ASTM D570 and preferably soluble in hydrocarbon or halogenated hydrocarbon solvents. Since the mixture of a desiccant and a specific resin is disposed inside the sealing member that encloses the organic EL structure, the resulting construction is very simple and fully effective for sealing the organic EL structure. The manufacturing process is simple. Since moisture is effectively removed, the deterioration with time of the device is effectively restrained.

The high molecular weight organic compound used in admixture with the desiccant should be low hygroscopic, and specifically have a water absorption of up to 1.0%, preferably up to 0.8%, as measured according to ASTM D570. This standard prescribes a water absorption test on plastic materials, and the water absorption is expressed by a percent weight gain of a test piece when immersed in distilled water at 23±1°C for 24 hours. The lower limit of water absorption is usually about 0.001% though not critical. If a high molecular weight organic compound having a greater water absorption is mixed with a desiccant, the water content the organic compound possesses can be adsorbed by the desiccant or chemically react with the desiccant, deteriorating the desiccant.

The high molecular weight organic compound used in admixture with the desiccant should preferably have a melting point of at least 100°C, and especially at least 150°C, though not limited thereto. If the organic compound's melting point is below 100°C, there is a possibility that a mixture of the desiccant and the organic compound flow in a certain service environment. There is also a possibility that the mixture flow upon solvent removal and drying after it is disposed or coated on the inside surface of the sealing member.

The high molecular weight organic compound should preferably be soluble in hydrocarbon and halogenated hydrocarbon solvents for ease of application as by coating and not readily react with the desiccant. Exemplary high molecular weight organic compounds are polyethylene (PE) resins, polypropylene (PP) resins, norbornene resins, polystyrene resins (GP-PS), polyvinyl chloride, and polycarbonate (PC) resins.

Before application, the high molecular weight organic compound is dissolved in a hydrocarbon or halogenated hydrocarbon solvent. The hydrocarbon or halogenated hydrocarbon solvent used for dissolution is selected from those solvents in which the high molecular weight organic compound is soluble and which do not readily chemically react with the desiccant to be admixed. The solvents should also preferably be less hygroscopic because any water content therein can deteriorate the desiccant. Fluorine, chlorine, bromine and iodine are included in the halogen of the halogenated hydrocarbon. Examples of the hydrocarbon or halogenated hydrocarbon solvent include hexane, heptane, octane, cyclohexane, ethylcyclohexane, benzene, toluene, xylene, ethylbenzene, dichloromethane, chloroform, carbon tetrachloride, dichloroethane, trichloroethane, tetrachloroethane, dichloropropane, and chlorobenzene.

About 10 to 150 parts, especially about 20 to 100 parts by weight of the high molecular weight organic compound is added to and dissolved in 100 parts by weight of the solvent.

The desiccant used herein in combination with the high molecular weight organic compound is not critical as long as it is effective for absorbing moisture even when bound in the resin. Exemplary desiccants include sodium oxide (Na₂O), potassium oxide (K₂O), calcium oxide (CaO), barium oxide (BaO), and magnesium oxide (MgO). Also useful are calcium hydride (CaH₂), strontium hydride (SrH₂), barium hydride (BaH₂), and aluminum lithium hydride (AlLiH₄). Of these desiccants, calcium hydride, strontium hydride, barium hydride, and aluminum lithium hydride are preferred.

On use, the desiccant is generally dispersed in the resin. The desiccant in particle form has a mean particle size of about 0.1 to 10 µm though not limited thereto. An appropriate content of the desiccant is about 5 to 80% by weight, and especially about 20 to 70% by weight based on the mixture of desiccant and resin. A desiccant content of less than 5% by weight may fail to impart a sufficient moisture absorbing effect to the mixture. With a desiccant content of more than 80% by weight, it may become difficult to carry and support the desiccant by the resin, leaving the risk that the EL structure can be damaged by falling desiccant particles.

An appropriate amount of the mixture of the organic compound and the desiccant applied to the sealing member is 0.001 to 0.5 g/cm², and especially 0.01 to 0.1 g/cm² although the amount varies with the specific gravity of the components used. Any application techniques including roll coating, blade coating, brush coating, and printing may be used while the use of a dispenser is also acceptable.

Referring to FIG. 1, there is illustrated one exemplary construction of the organic EL device according to the invention. On a substrate 1 is formed an organic EL structure 2. A sealing member 3 is placed on the substrate 1 so that the sealing member 3 encloses the organic EL structure 2 and is spaced therefrom. Specifically the sealing member 3 is secured to the substrate 1 with an adhesive 4 to define a sealed space between the sealing member 3 and the EL structure 2. A mixture 5 of a desiccant and an organic compound is disposed inside the sealing member 3, that is, on the inside surface of the sealing member 3 facing the EL structure 2. The mixture is preferably kept out of contact with the EL structure 2.

The sealing member is preferably in the form of a flat plate and is generally made of transparent or translucent materials such as glass, quartz and resins, with glass being preferred. The use of a flat glass plate enables the low-cost manufacture of a thin organic EL display assembly. As the glass material, alkali glass is preferred from the economical aspect. Other preferred glass compositions are soda lime glass, lead alkali glass, borosilicate glass, aluminosilicate glass, and silica glass. Among others, surface-untreated plates of soda lime glass are preferred partially because of their low cost. Besides the plate glass, metal plates and plastic plates may be used as the sealing member.

The size of the sealing member is not particularly limited. The sealing member is appropriately sized in accordance with the design of a display area and the circuit design. Typically, the sealing member is about 0.1 to 5 mm thick when it is a flat plate. As in the illustrated embodiment, the sealing member may have a recess where the organic EL structure is partially or entirely received.

Means for adjusting the height of the sealing member above the substrate is preferably a spacer though not limited thereto. The use of a spacer enables low-cost easy adjustment to the desired height. The spacer may be made of resin beads, silica beads, glass beads, and glass fibers, with the glass beads being especially preferred. The spacer is generally comprised of particles having a narrow size distribution. The shape of spacer particles is not critical. Particles of various shapes may be used as long as they can serve as the spacer. The size of spacer particles is preferably about 1 to 20 µm, more preferably about 1 to 10 µm, and most preferably about 2 to 8 µm, as expressed in equivalent circle diameter. Particles having a diameter within the range preferably have a length of less than about 100 µm. The lower limit of length is not critical although it is at least equal to the diameter.

Where the sealing member is provided with a recess, the spacer may or may not be used. The spacer, if used, preferably has a size within the above-defined range, especially of 2 to 8 µm.

The spacer may be premixed with a sealing adhesive or mixed with a sealing adhesive when applied. The content of the spacer in the sealing adhesive is preferably 0.01 to 30% by weight, and more preferably 0.1 to 5% by weight.

As the sealing adhesive used herein, adhesives of thermosetting type may be used, although adhesives of photo-curing type are preferred when their influence on the organic EL structure is considered. Examples include radical adhesives based on various acrylates (e.g., ester acrylates, urethane acrylates, epoxy acrylates, melamine acrylates, and acrylic resin acrylates) and urethane polyesters, cationic adhesives based on such resins as epoxy resins and vinyl ether resins, and thiol-ene addition type resin base adhesives. Of these, preferred are cationic adhesives which are free of oxygen hindrance and allow polymerization reaction to proceed even after light irradiation.

The cationic adhesive is preferably a UV curable epoxy resin-base adhesive of the cation curing type. The materials of the respective layers of the organic EL multilayer structure generally have a glass transition temperature of less than about 140°C, especially about 80 to 100°C. If conventional adhesives of the thermosetting type having a curing temperature of about 140 to 180°C are used, the organic EL structure softens upon curing of the adhesive, detracting from its characteristics. By contrast, UV curing type adhesives do not cause such softening of the organic EL structure. However, most UV curable adhesives commonly used at present are acrylic and thus have the problem that the acrylic monomer contained therein volatilizes upon curing and adversely affects the materials of the respective layers of the organic EL structure to deteriorate their characteristics. For this reason, a UV curable epoxy resin-base adhesive of the cation curing type which eliminates or substantially eliminates the above problem is used in the practice of the invention.

Among commercially available UV curable epoxy resin-base adhesives, epoxy resin-base adhesives of the combined UV/heat curing type are included. Most of these adhesives in which an acrylic resin of the radical curing type and an epoxy resin of the heat curing type are mixed or modified have not solved the problem of volatilization of acrylic monomer associated with the acrylic resins and the problem of curing temperature associated with the thermosetting epoxy resins. These adhesives are thus not suited for use with the organic EL device according to the invention.

The UV curable epoxy resin-base adhesive of the cation curing type is a composition comprising an epoxy resin as a base resin and a Lewis acid salt type curing agent capable of releasing a Lewis acid catalyst through photolysis upon exposure to light, typically ultraviolet radiation, as a main curing agent wherein the Lewis acid generated by light irradiation serves as a catalyst for the epoxy resin to polymerize through a cation polymerization type reaction mechanism until it is cured.

The epoxy resin as the base resin of the adhesive may be selected from among epoxidized olefin resins, alicyclic epoxy resins, and novolac epoxy resins. Examples of the curing agent include Lewis acid salts of aromatic diazonium, Lewis acid salts of diallyl iodonium, Lewis acid salts of triallyl sulfonium, and Lewis acid salts of triallyl selenium. Of these, Lewis acid salts of diallyl iodonium are preferred.

An appropriate amount of the adhesive applied is about 6x10⁻² to 2x10⁻⁴ g/cm², and especially about 8x10⁻³ to 2x10⁻⁴ g/cm² although the amount varies with the size of the organic EL structure and the type and organization of the display constructed by the organic EL device. The thickness of the adhesive layer should be sufficient to position the sealing member at a predetermined height above the substrate, that is, to provide a predetermined space above the organic EL structure on the substrate. In this sense, the thickness of the adhesive layer is generally about 5x10⁵ to 1x10³ nm, preferably about 5x10⁴ to 5x10³ nm, and more preferably about 2x10⁴ to 2x10³ nm, though not limited thereto.

When the sealing member is attached to the EL structure-carrying substrate with the adhesive to seal the space, the space preferably contains a filler gas. The preferred filler gas is an inert gas such as argon (Ar), helium (He) or nitrogen (N₂). The filler gas should preferably have a water content of up to about 100 ppm, more preferably up to about 10 ppm, and most preferably up to about 1 ppm. The lower limit of the water content is usually about 0.1 ppm though not critical.

As described above, transparent or translucent materials such as glass, quartz and resins are used as the substrate when light emitted by the EL structure exits from the substrate side. In the case of inversely stacked structure, the substrate may be either transparent or opaque, ceramics being useful as the opaque substrate.

The substrate may be provided with a color filter film, a fluorescent material-containing color conversion film or a dielectric reflecting film for controlling the color of light emission.

The color filter film used herein may be a color filter as used in liquid crystal displays and the like. The properties of a color filter may be adjusted in accordance with the light emission of the organic EL device so as to optimize the extraction efficiency and color purity. It is also preferred to use a color filter capable of cutting external light of short wavelength which is otherwise absorbed by the EL device materials and fluorescence conversion layer, because the light resistance and display contrast of the device are improved. An optical thin film such as a dielectric multilayer film may be used instead of the color filter.

The fluorescence conversion filter film is to convert the color of light emission by absorbing electroluminescence and allowing the fluorescent material in the film to emit light. It is formed from three components: a binder, a fluorescent material, and a light absorbing material. The fluorescent material used may basically have a high fluorescent quantum yield and desirably exhibits strong absorption in the electroluminescent wavelength region. In practice, laser dyes are appropriate. Use may be made of rhodamine compounds, perylene compounds, cyanine compounds, phthalocyanine compounds (including sub-phthalocyanines), naphthalimide compounds, fused ring hydrocarbon compounds, fused heterocyclic compounds, styryl compounds, and coumarin compounds. The binder is selected from materials which do not cause extinction of fluorescence, preferably those materials which can be finely patterned by photolithography or printing technique. Also, where the filter film is formed on the substrate so as to be contiguous to the hole injecting electrode, those materials which are not damaged during deposition of the hole injecting electrode (such as ITO or IZO) are preferable. The light absorbing material is used when the light absorption of the fluorescent material is short, and may be omitted if unnecessary. The light absorbing material may also be selected from materials which do not cause extinction of fluorescence of the fluorescent material.

Next, the organic EL structure constructing the organic EL device according to the invention is described. The organic EL structure includes on a substrate, a hole injecting electrode, an electron injecting electrode, and at least one organic layer disposed between the electrodes. The organic layer includes at least one hole transporting layer and at least one light emitting layer, on which the electron injecting electrode is disposed. A protective electrode may be disposed as the uppermost layer. The hole transporting layer may be omitted.

A transparent or translucent electrode is preferred as the hole injecting electrode because it is formed as an electrode on the substrate side and emitted light is to exit from the substrate side. Useful materials for transparent electrodes include tin-doped indium oxide (ITO), zinc-doped indium oxide (IZO), zinc oxide (ZnO), tin oxide (SnO₂), and indium oxide (In₂O₃), with ITO and IZO being preferred. Usually ITO contains In₂O₃ and SnO₂ in stoichiometry, while the oxygen content may deviate more or less therefrom.

The hole injecting electrode may have a sufficient thickness for hole injection and is preferably about 10 to about 500 nm thick, especially about 30 to 300 nm thick. Although no particular upper limit is imposed on the thickness of the electrode, too thick an electrode may have undesirable problems including separation, difficult processing, stress failure, lowering of light transmission, and leakage due to surface roughness. Inversely, too thin an electrode may have problems including film strength during preparation, hole transporting capability, and resistivity.

The hole injecting electrode layer can be formed by evaporation or other processes although sputtering is preferable.

The electrode on the light output side preferably has a transmittance of at least 50%, more preferably at least 60%, further preferably at least 80%, and especially at least 90% for each light emission in a luminous wavelength band, typically of 400 to 700 nm. The electrode with a low transmittance causes the light emission from the light emitting layer to attenuate, failing to provide a necessary luminance as the light emitting device. Where it is desired to increase the contrast for improving visibility, the electrode is given a relatively low transmittance.

The electron injecting electrode is preferably formed from materials having a low work function, for example, metal elements such as K, Li, Na, Mg, La, Ce, Ca, Sr, Ba, Al, Ag, In, Sn, Zn, and Zr, and binary or ternary alloys made of two or three such metal elements for stability improvement. Exemplary alloys are Ag-Mg (Ag: 1 to 20 at%), Al-Li (Li: 0.3 to 14 at%), In-Mg (Mg: 50 to 80 at%), and Al-Ca (Ca: 5 to 20 at%). Oxides of these metals may also be formed in combination with an auxiliary electrode. It is understood that the electron injecting electrode can also be formed by evaporation or sputtering.

The electron injecting electrode thin film may have a sufficient thickness for electron injection, for example, a thickness of at least 0.1 nm, preferably at least 1 nm. Although the upper limit is not critical, the electrode thickness is typically about 1 to about 500 nm. On the electron injecting electrode, a protective electrode may be provided, if desired.

The protective electrode has a thickness sufficient to ensure efficient electron injection and prevent ingress of moisture, oxygen and organic solvents, preferably a thickness of at least 50 nm, more preferably at least 100 nm, and especially 100 to 1,000 nm. Too thin a protective electrode layer would fail to achieve the above effects or to provide step coverage so that its connection to a terminal electrode becomes insufficient. Too thick a protective electrode layer would accumulate more stresses, resulting in an increased growth rate of dark spots.

The total thickness of the electron injecting electrode and the protective electrode combined is preferably about 100 to 1,000 nm though not critical.

Following the electrode formation, a protective film may be formed in addition to the protective electrode, using an inorganic material such as SiOx or an organic material such as Teflon and chlorine-containing fluorinated hydrocarbon polymers. The protective film may be either transparent or opaque and have a thickness of about 50 to 1,200 nm. Apart from the reactive sputtering process, the protective film may also be formed by an ordinary sputtering, evaporation or PECVD process.

Next, the organic material layers included in the organic EL structure are described.

The light emitting layer is a laminated film comprising an organic compound thin film of at least one type participating in at least a light emitting function.

The light emitting layer has the functions of injecting holes and electrons, transporting them, and recombining holes and electrons to create excitons. The use of relatively electronically neutral compounds in the light emitting layer enables effective and well-balanced injection and transportation of electrons and holes.

If desired, the light emitting layer includes a hole injecting and transporting layer and an electron injecting and transporting layer both of organic compounds as well as the light emitting layer in a narrower sense.

The hole injecting and transporting layer has the functions of facilitating injection of holes from the hole injecting electrode, transporting holes stably, and blocking electrons. The electron injecting and transporting layer has the functions of facilitating injection of electrons from the electron injecting electrode, transporting electrons stably, and blocking holes. These layers are effective for increasing the number of holes and electrons injected into the light emitting layer and confining holes and electrons therein for optimizing the recombination region to improve light emission efficiency.

The thicknesses of the light emitting layer, the hole injecting and transporting layer, and the electron injecting and transporting layer are not critical and vary with a particular formation technique. Usually, their thickness is preferred to range from about 5 nm to about 500 nm, especially about 10 nm to about 300 nm.

The thickness of the hole injecting and transporting layer and the electron injecting and transporting layer is equal to or ranges from about 1/10 times to about 10 times the thickness of the light emitting layer although it depends on the design of a recombination/light emitting region. When the electron or hole injecting and transporting layer is divided into an injecting layer and a transporting layer, preferably the injecting layer is at least 1 nm thick and the transporting layer is at least 1 nm thick. The upper limit of thickness is usually about 500 nm for the injecting layer and about 500 nm for the transporting layer. The same film thickness applies when two injecting/transporting layers are provided.

The light emitting layer of the organic EL device contains a fluorescent material that is a compound having a light emitting capability. The fluorescent material may be at least one member selected from compounds as disclosed, for example, in JP-A 63-264692, such as quinacridone, rubrene, and styryl dyes. Also, quinoline derivatives such as metal complex dyes having 8-quinolinol or a derivative thereof as the ligand such as tris(8-quinolinolato)aluminum are included as well as tetraphenylbutadiene, anthracene, perylene, coronene, and 12-phthaloperinone derivatives. Further useful are the phenylanthracene derivatives described in JP-A 8-12600 and the tetraarylethene derivatives described in JP-A 8-12969.

It is preferred to use such a compound in combination with a host material capable of light emission by itself, that is, to use the compound as a dopant. In this embodiment, the content of the compound in the light emitting layer is preferably 0.01 to 10% by weight, especially 0.1 to 5% by weight. By using the compound in combination with the host material, the light emission wavelength of the host material can be altered, allowing light emission to be shifted to a longer wavelength and improving the luminous efficacy and stability of the device.

As the host material, quinolinolato complexes are preferable, with aluminum complexes having 8-quinolinol or a derivative thereof as the ligand being more preferable. These aluminum complexes are disclosed in JP-A 63-264692, 3-255190, 5-70773, 5-258859 and 6-215874.

Illustrative examples include tris(8-quinolinolato)aluminum, bis(8-quinolinolato)magnesium, bis(benzo{*f*}-8-quinolinolato)zinc, bis(2-methyl-8-quinolinolato)aluminum oxide, tris(8-quinolinolato)indium, tris(5-methyl-8-quinolinolato)aluminum, 8-quinolinolatolithium, tris(5-chloro-8-quinolinolato)gallium, bis(5-chloro-8-quinolinolato)calcium, 5,7-dichloro-8-quinolinolatoaluminum, tris(5,7-dibromo-8-hydroxyquinolinolato)aluminum, and poly[zinc(II)-bis(8-hydroxy-5-quinolinyl)methane].

Also useful are aluminum complexes having another ligand in addition to 8-quinolinol or a derivative thereof. Examples include bis(2-methyl-8-quinolinolato)(phenolato)aluminum(III), bis(2-methyl-8-quinolinolato)(ortho-cresolato)aluminum(III), bis(2-methyl-8-quinolinolato)(meta-cresolato)aluminum(III), bis(2-methyl-8-quinolinolato) (para-cresolato)aluminum(III), bis(2-methyl-8-quinolinolato)(ortho-phenylphenolato)aluminum(III), bis(2-methyl-8-quinolinolato)(meta-phenylphenolato)aluminum(III), bis(2-methyl-8-quinolinolato)(para-phenylphenolato)aluminum(III), bis(2-methyl-8-quinolinolato) (2,3-dimethylphenolato)aluminum(III), bis(2-methyl-8-quinolinolato)(2,6-dimethylphenolato)aluminum(III), bis(2-methyl-8-quinolinolato)(3,4-dimethylphenolato)aluminum(III), bis(2-methyl-8-quinolinolato)(3,5-dimethylphenolato)aluminum(III), bis(2-methyl-8-quinolinolato) (3,5-di-tert-butylphenolato)aluminum(III), bis(2-methyl-8-quinolinolato)(2,6-diphenylphenolato)aluminum(III), bis(2-methyl-8-quinolinolato)(2,4,6-triphenylphenolato)aluminum(III), bis(2-methyl-8-quinolinolato)(2,3,6-trimethylphenolato)aluminum(III), bis(2-methyl-8-quinolinolato)(2,3,5,6-tetramethylphenolato)aluminum(III), bis(2-methyl-8-quinolinolato)(1-naphtholato)aluminum(III), bis(2-methyl-8-quinolinolato)(2-naphtholato)aluminum(III), bis(2,4-dimethyl-8-quinolinolato)(ortho-phenylphenolato)aluminum(III), bis(2,4-dimethyl-8-quinolinolato)(para-phenylphenolato)aluminum(III), bis(2,4-dimethyl-8-quinolinolato)(metaphenylphenolato)aluminum(III), bis(2,4-dimethyl-8-quinolinolato) (3,5-dimethylphenolato)aluminum(III), bis(2,4-dimethyl-8-quinolinolato)(3,5-di-tert-butylphenolato)aluminum(III), bis(2-methyl-4-ethyl-8-quinolinolato)(para-cresolato)aluminum(III), bis(2-methyl-4-methoxy-8-quinolinolato)(para-phenylphenolato)aluminum(III), bis(2-methyl-5-cyano-8-quinolinolato)(orthocresolato)aluminum(III), and bis(2-methyl-6-trifluoromethyl-8-quinolinolato)(2-naphtholato)aluminum(III).

Also acceptable are bis(2-methyl-8-quinolinolato)aluminum(III)-µ-oxo-bis(2-methyl-8-quinolinolato)aluminum (III), bis(2,4-dimethyl-8-quinolinolato)aluminum(III)-µ-oxo-bis(2,4-dimethyl-8-quinolinolato)aluminum(III), bis(4-ethyl-2-methyl-8-quinolinolato)aluminum(III)-µ-oxo-bis(4-ethyl-2-methyl-8-quinolinolato)aluminum(III), bis(2-methyl-4-methoxyquinolinolato)aluminum(III)-µ-oxo-bis(2-methyl-4-methoxyquinolinolato)aluminum(III), bis(5-cyano-2-methyl-8-quinolinolato)aluminum(III)-µ-oxo-bis(5-cyano-2-methyl-8-quinolinolato)aluminum(III), and bis(2-methyl-5-trifluoromethyl-8-quinolinolato)aluminum(III)-µ-oxo-bis(2-methyl-5-trifluoromethyl-8-quinolinolato)aluminum(III).

Other useful host materials are the phenylanthracene derivatives described in JP-A 8-12600 and the tetraarylethene derivatives described in JP-A 8-12969.

The light emitting layer may also serve as the electron injecting and transporting layer. In this case, tris(8-quinolinolato)aluminum etc. are preferably used. These fluorescent materials may be evaporated.

Also, if necessary, the light emitting layer may be a layer of a mixture of at least one hole injecting and transporting compound and at least one electron injecting and transporting compound, in which a dopant is preferably contained. In such a mix layer, the content of the dopant is preferably 0.01 to 20% by weight, especially 0.1 to 15% by weight.

In the mix layer, carrier hopping conduction paths are created, allowing carriers to move through a polarly predominant material while injection of carriers of opposite polarity is rather inhibited, and the organic compound becomes less susceptible to damage, resulting in the advantage of an extended device life. By incorporating the aforementioned dopant in such a mix layer, the light emission wavelength the mix layer itself possesses can be altered, allowing light emission to be shifted to a longer wavelength and improving the luminous intensity and stability of the device.

The hole injecting and transporting compound and electron injecting and transporting compound used in the mix layer may be selected from compounds for the hole injecting and transporting layer and compounds for the electron injecting and transporting layer to be described later, respectively. Inter alia, the compound for the hole injecting and transporting layer is preferably selected from amine derivatives having strong fluorescence, for example, triphenyldiamine derivatives which are hole transporting materials, styrylamine derivatives and amine derivatives having an aromatic fused ring.

The electron injecting and transporting compound is preferably selected from quinoline derivatives and metal complexes having 8-quinolinol or a derivative thereof as a ligand, especially tris(8-quinolinolato)aluminum (Alq3). The aforementioned phenylanthracene derivatives and tetraarylethene derivatives are also preferable.

For the hole injecting and transporting layer, amine derivatives having intense fluorescence are useful, for example, the triphenyldiamine derivatives, styrylamine derivatives, and amine derivatives having an aromatic fused ring, exemplified above as the hole transporting material.

The mix ratio is preferably determined in accordance with the carrier density and carrier mobility. It is usually preferred that the weight ratio of the hole injecting and transporting compound to the electron injecting and transporting compound range from about 1/99 to about 99/1, more preferably from about 10/90 to about 90/10, especially from about 20/80 to about 80/20.

Also preferably, the thickness of the mix layer ranges from the thickness of a mono-molecular layer to less than the thickness of the organic compound layer, specifically from 1 to 85 nm, more preferably 5 to 60 nm, especially 5 to 50 nm.

Preferably the mix layer is formed by a co-deposition process of evaporating the compounds from distinct sources. If both the compounds have approximately equal or very close vapor pressures or evaporation temperatures, they may be pre-mixed in a common evaporation boat, from which they are evaporated together. The mix layer is preferably a uniform mixture of both the compounds although the compounds can be present in island form. The light emitting layer is generally formed to a predetermined thickness by evaporating an organic fluorescent material or coating a dispersion thereof in a resin binder.

In the hole injecting and transporting layer, there may be used various organic compounds as described, for example, in JP-A 63-295695, 2-191694, 3-792, 5-234681, 5-239455, 5-299174, 7-126225, 7-126226, and 8-100172, and EP 0650955A1. Exemplary are tetraarylbenzidine compounds (triaryldiamines or triphenyldiamines: TPD), aromatic tertiary amines, hydrazone derivatives, carbazole derivatives, triazole derivatives, imidazole derivatives, oxadiazole derivatives having an amino group, and polythiophenes. Two or more of these compounds may be used, and on such combined use, they may be formed as separate layers or mixed.

In the electron injecting and transporting layer, there may be used quinoline derivatives including organic metal complexes having 8-quinolinol or a derivative thereof as a ligand such as tris(8-quinolinolato)aluminum (Alq3), oxadiazole derivatives, perylene derivatives, pyridine derivatives, pyrimidine derivatives, quinoxaline derivatives, diphenylquinone derivatives, and nitro-substituted fluorene derivatives. The electron injecting and transporting layer can also serve as the light emitting layer. In this case, use of tris(8-quinolinolato)aluminum etc. is preferred. Like the light emitting layer, the electron injecting and transporting layer may be formed by evaporation or the like.

Where the electron injecting and transporting layer is formed separately as an electron injecting layer and an electron transporting layer, two or more compounds are selected in a proper combination from the compounds commonly used in electron injecting and transporting layers. In this regard, it is preferred to stack layers in such an order that a layer of a compound having a greater electron affinity may be disposed adjacent the electron injecting electrode. The order of stacking also applies where a plurality of electron injecting and transporting layers are provided.

In forming the hole injecting and transporting layer, the light emitting layer, and the electron injecting and transporting layer, vacuum evaporation is preferably used because homogeneous thin films are available. By utilizing vacuum evaporation, there is obtained a homogeneous thin film which is amorphous or has a crystal grain size of less than 0.2 µm. If the grain size is more than 0.2 µm, uneven light emission would take place and the drive voltage of the device must be increased with a substantial drop of hole injection efficiency.

The conditions for vacuum evaporation are not critical although a vacuum of 10⁻⁴ Pa or lower and a deposition rate of about 0.01 to 1 nm/sec are preferred. It is preferred to successively form layers in vacuum because the successive formation in vacuum can avoid adsorption of impurities on the interface between the layers, thus ensuring better performance. Also, the drive voltage of a device can be reduced and the development and growth of dark spots be restrained.

In the embodiment wherein the respective layers are formed by vacuum evaporation, where it is desired for a single layer to contain two or more compounds, boats having the compounds received therein are individually temperature controlled to achieve co-deposition.

The organic EL device of the invention is generally of the dc or pulse drive type while it can be of the ac drive type. The applied voltage is generally about 2 to 30 volts.

### EXAMPLE

Examples of the present invention are given below by way of illustration and not by way of limitation.

### Preparation of desiccant/resin mixture sample

A polystyrene having a number average molecular weight of 350,000 and a water absorption of 0.04 to 0.06% as measured at 23°C for 24 hours according to ASTM D570 was used as the resin, toluene used as the solvent, and calcium hydride (CaH₂) used as the desiccant. In a nitrogen atmosphere, 50 parts by weight of the resin was added to 100 parts by weight of the solvent and dissolved therein by agitation, following which 50 parts by weight of the desiccant was added. They were mixed and agitated, obtaining a desiccant/resin mixture solution. The solution was applied to the inside surface of a sealing glass plate (which was to face an organic EL structure when assembled). The coated glass plate was heated at 150°C for removing the solvent and drying the coating. The coated glass plate was cooled down to room temperature. At room temperature, the desiccant/resin mixture solidified and gave rise to no flow phenomenon. The amount of the mixture coated was about 0.05 g/cm². It was confirmed that the desiccant was secured to the sealing glass plate by a very easy process.

For comparison purposes, there was furnished a glass plate to which the desiccant/resin mixture was not coated (Comparative Example 1).

Another sample (Comparative Example 2) was prepared by using cellulose triacetate having a water absorption of 2 to 4.5% as measured at 23°C for 24 hours according to ASTM D570, dissolving 30 parts by weight of the cellulose triacetate in 100 parts by weight of dichloromethane, and adding 30 parts by weight of the desiccant CaH₂ thereto to form a desiccant/resin mixture solution, and coating a glass plate with the solution.

### Preparation of organic EL device

A 7059 glass substrate (Corning Glass Works) was scrubbed using a neutral detergent. By effecting RF magnetron sputtering of an indium tin oxide target while setting the glass substrate at 250°C, an ITO hole injecting electrode layer was formed on the glass substrate to a thickness of 200 nm. The substrate having the ITO electrode layer formed thereon was surface cleaned with UV/ozone.

The substrate was then secured by a holder in a vacuum evaporation chamber, which was evacuated to a vacuum of 1x10⁻⁴ Pa or lower. 4,4',4"-tris(N-(3-methylphenyl)-N-phenylamino)triphenylamine (m-MTDATA) was evaporated at a deposition rate of 0.1 nm/sec. to a thickness of 55 nm, forming a hole injecting layer. Then, N,N'-diphenyl-N,N'-m-tolyl-4,4'-diamino-1,1'-biphenyl (TPD) was evaporated at a deposition rate of 0.1 nm/sec to a thickness of 20 nm, forming a hole transporting layer.

With the vacuum kept, N,N,N',N'-tetrakis(m-biphenyl)-1,1'-biphenyl-4,4'-diamine (TPD), tris(8-quinolinolato)aluminum (Alq3), and rubrene were evaporated at an overall deposition rate of 0.2 nm/sec to a thickness of 100 nm, forming a light emitting layer. The light emitting layer was a mixture of TPD and Alq3 in a weight ratio of 1:1, doped with 10% by volume of rubrene.

With the vacuum kept, AlLi (Li, 7 at%) was evaporated to a thickness of 1 nm, and aluminum was successively evaporated to a thickness of 200 nm, forming an electron injecting electrode and an auxiliary electrode, respectively.

The sealing glass plate having the desiccant/resin mixture coated on the inside surface was laid on the substrate so as to enclose the EL structure inside and secured thereto with an epoxy resin adhesive of the photo-curing type, completing an EL assembly. For comparison purposes, the glass plate without the desiccant/resin mixture coating and the glass plate coated with the desiccant/cellulose triacetate mixture were similarly secured to the substrates, forming comparative EL assemblies (Comparative Examples 1 and 2).

In an environment of 60°C and RH 95%, ten samples for each of the EL assemblies were continuously driven at a current density of 10 mA/cm². After 500 hours of continuous driving, the light emitting surface was visually observed to count dark spots per pixel. In the assembly within the scope of the invention, only about two dark spots having a diameter of less than 50 µm were found. In Comparative Examples 1 and 2, 10 to 15 or more dark spots having a diameter of more than 50 µm were found.

There has been described an organic EL device which effectively suppresses the deterioration with time of the device including a reduction of luminance with the lapse of driving time and the development and growth of dark spots, maintains its initial performance over a long period of time, and can be manufactured through simple sealing steps at low cost.

Japanese Patent Application No. 10-370279 is incorporated herein by reference.

The invention has been described in detail with particular reference to preferred embodiments thereof, but it will be understood that variations and modifications can be effected within the spirit and scope of the invention.

## Claims

1. An organic electroluminescent device comprising a substrate, an organic electroluminescent structure formed on the substrate, and a sealing member enclosing the organic electroluminescent structure for providing a seal thereto,
a mixture of a desiccant and a high molecular weight organic compound having a water absorption of up to 1.0% as measured at 23°C for 24 hours according to ASTM D570 being disposed on the inside surface of said sealing member.

2. The device of claim 1 wherein said high molecular weight organic compound is soluble in hydrocarbon or halogenated hydrocarbon solvents.
